# FASCICULE DE BREVET EUROPEEN

(11) **EP 0 614 282 B1**
(45) Date de publication et mention de la délivrance du brevet: **19.11.1997**
(21) Numéro de dépôt: 94200489.6
(22) Date de dépôt: 24.02.1994
(51) Int. Cl.: H03L 7/089

(54) **Circuit de pompe de charge à faible consommation, faible bruit et synthétiseur de fréquence équipé d'un tel circuit**
Rauscharme Ladepumpe mit niedrigem Verbrauch und Frequenzsynthesizer, ausgestattet mit einer solchen Schaltung
Low noise charge pump having low consumption and frequency synthesiser equipped with such

(30) Priorité: 03.03.1993 FR 9302464
(43) Date de publication de la demande: 07.09.1994
(73) Titulaire: PHILIPS COMPOSANTS ET SEMICONDUCTEURS, 92150 Suresnes (FR); Philips Electronics N.V., 5621 BA Eindhoven (NL)
(72) Inventeur: Dufour, Yves, Société Civile S.P.I.D., F-75008 Paris (FR)
(74) Mandataire: Charpail, François

(56) Documents cités:
- EP-A- 0 238 041
- EP-A- 0 484 059
- DE-A- 3 813 550
- GB-A- 2 075 294
- US-A- 4 847 519
- PROCEEDINGS OF THE IEEE 1990 CUSTOM INTEGRATED CIRCUITS CONFERENCE, 13 Mai 1990, BOSTON, MA., US pages 15.1.1 - 15.1.4 G. GUTIERREZ ET AL. 'An Integrated PLL Clock Generator for 275 MHz Graphic Displays'

## Description

La présente invention concerne un circuit pompe de charge comportant à partir d'une première borne d'alimentation, une première et une deuxième source de courant de construction semblable, dont le courant débité en direction d'une deuxième borne d'alimentation est nominalement identique, lesdites sources étant activées indépendamment et cycliquement par des signaux de commande, respectivement un signal dit de descente et un signal dit de montée, circuit qui comporte également un miroir de courant dont l'entrée est insérée dans la liaison de la première source de courant vèrs la deuxième borne d'alimentation, et dont la sortie est connectée à la sortie de la deuxième source de courant, connexion qui constitue une borne de sortie du circuit pompe de charge.

Un tel circuit pompe de charge est connu du document US-A-4 847 519.

Le circuit connu par ce document comporte deux sources de courant sous la forme de deux étages différentiels fonctionnant sous une commande cyclique des signaux de descente et de montée, une impulsion de charge étant fournie en sortie pendant un intervalle de temps pendant lequel une seulement des deux sources de courant, est active. Durant le reste d'un cycle de la commande cyclique, les sources de courant sont soit inactivées, soit actives simultanément ce qui ne fournit aucune charge à la sortie du circuit. Les impulsions de charges en sortie du circuit sont stockées dans une capacité réservoir.

Si la disposition du circuit connu offre l'avantage d'utiliser deux sources de courant qui peuvent être construites de manière très semblables et peuvent donc, de ce fait, être convenablement appairées, il présente le grave inconvénient de consommer en permanence le courant total des deux sources de courant, du fait du montage différentiel utilisé.

En ce qui concerne les caractéristiques de bruit en sortie d'un circuit pompe de charge de ce type, une analyse détaillée des phénomènes indique que le bruit moyen, est sensiblement proportionnel au rapport cyclique des signaux commande, le bruit étant pratiquement nul pendant la portion du cycle où les sources de courant sont toutes les deux inactives. Pour diminuer le bruit moyen en sortie, il est donc avantageux d'utiliser des signaux de commande ayant un rapport cyclique le plus petit possible. Par ailleurs, l'aptitude d'un circuit pompe de charge à changer rapidement de valeur en sortie, en réponse à une variation instantanée de la phase d'un oscillateur à contrôler, cette aptitude sera favorisée lorsque les sources de courant débitent un courant élevé, par exemples plusieurs milliampères voire quelques dizaines de milliampères.

Le circuit pompe de charge de l'art antérieur ne peut donc pas convenir à des applications où la consommation de courant doit être limitée au maximum comme c'est le cas pour des appareils portatifs, alimentés par piles ou batteries.

La présente invention a pour but de remédier aux inconvénients précités. Elle propose un circuit pompe de charge avec lequel la consommation d'énergie est nettement moins élevée qu'avec le circuit connu, et dont le bruit en sortie est notablement réduit.

En effet, selon l'invention, un circuit pompe de charge conforme au paragraphe introductif est notamment remarquable en ce que les première et deuxième sources de courant étant essentiellement constituées respectivement d'un premier et d'un deuxième transistors, l'électrode de commande de chacun d'eux est reliée à la sortie d'un générateur de tension de référence, commun aux deux transistors, via, pour le premier transistor, un premier commutateur à transistors commandé par le signal de descente, et pour le deuxième transistor, via un deuxième commutateur à transistors commandé par le signal de montée, et en ce que le générateur de tension de référence comporte un troisième transistor, de construction semblable au premier et au deuxième transistor, une source de courant de référence en série avec le troisième transistor, et des moyens pour imposer que le courant traversant ce troisième transistor soit égal au courant de ladite source de courant de référence, l'électrode de commande du troisième transistor présentant ladite tension de référence à appliquer aux électrodes de commande des premier et deuxième transistors.

Ainsi, selon l'invention, les première et deuxième sources de courant ne débitent que pendant le temps où elles sont activées, temps qui est défini par les rapports cycliques des signaux de commande qui peuvent être aussi petits que 1/10⁴, alors que le troisième transistor est seul à débiter en permanence le courant de référence fourni par la source de courant de référence. Or en pratique, un générateur de tension de référence tel que défini peut être utilisé pour alimenter une pluralité de premières et deuxièmes sources de courant de sorte que le courant consommé en moyenne reste très modéré.

Comme l'électrode de commande des premier et deuxième transistors est alimentée à partir du même générateur de tension de référence, le bruit qui pourrait être présent à la sortie de ce générateur se trouve essentiellement éliminé en sortie du circuit dans la phase du cycle durant laquelle les deux sources de courant sont activées simultanément.

Selon un mode préféré de réalisation, le circuit pompe de charge selon l'invention est caractérisé en ce que le générateur de tension de référence comporte un amplificateur de contre-réaction, dont une première entrée est reliée à un noeud formé entre la source de courant de référence et l'électrode de sortie du troisième transistor, dont une seconde entrée est reliée à l'électrode de commande de ce troisième transistor et dont la sortie fournit ladite tension de référence.

L'amplificateur de contre-réaction peut donc être proportionné selon les applications au nombre et au courant débité par les sources de courant que ce générateur alimente. Comme l'électrode de sortie du troisième transistor est reliée à l'une des entrées de l'amplificateur de contre-réaction, le troisième transistor fonctionne sous une tension définie et constante.

De manière que le troisième transistor soit placé dans des conditions de fonctionnement les plus semblables possible par rapport au premier et deuxième transistor, on prévoit avantageusement qu'un quatrième transistor, tenant lieu d' d'interrupteur fermé en permanence, est inséré entre la seconde entrée de l'amplificateur de contreréaction et l'électrode de commande du troisième transistor, ce quatrième transistor étant de construction semblable à celle des transistors du premier et du deuxième commutateur qui commandent l'activation cyclique des premier et deuxième transistors de la pompe de charge.

On obtient par ce moyen que les sources de courant débitent un courant reproduisant le plus exactement possible le courant de référence produit dans le générateur de tension de référence. Le courant débité par les première et deuxième sources de courant est donc prévisible avec une grande précision.

On peut prévoir selon l'invention qu'un circuit pompe de charge comporte encore un dispositif de décalage de tension inséré à la première entrée de l'amplificateur de contre-réaction. Cette disposition permet de choisir une tension de fonctionnement du troisième transistor qui soit compatible avec les tensions d'alimentation et qui se rapproche des tensions de fonctionnement des premier et deuxième transistors.

Le circuit pompe de charge selon l'invention peut être réalisé soit à transistors à effet de champ de type MOS soit à transistors de type bipolaire soit encore et avantageusement à l'aide d'une combinaison de transistors de chacun de ces deux types.

L'invention concerne également un synthétiseur de fréquence incorporant au moins un circuit pompe de charge tel que précédemment défini.

D'autres détails caractéristiques et avantages de l'invention seront plus apparents à la lecture de la description qui va suivre au regard de dessins annexés donnés à titre d'exemple non limitatifs dans lesquels :
- la figure 1 représente un schéma électrique, partiellement sous forme de blocs, d'un circuit pompe de charge selon l'invention,
- la figure 2 montre un exemple de réalisation détaillé de deux commutateurs utilisés dans le circuit de la figure 1,
- la figure 3 représente un schéma électrique simplifié relatif à la mise en oeuvre d'un amplificateur de contre-réaction utilisé dans le circuit pompe de charge selon l'invention,
- et la figure 4, un mode préféré de réalisation d'un tel amplificateur de contre-réaction.

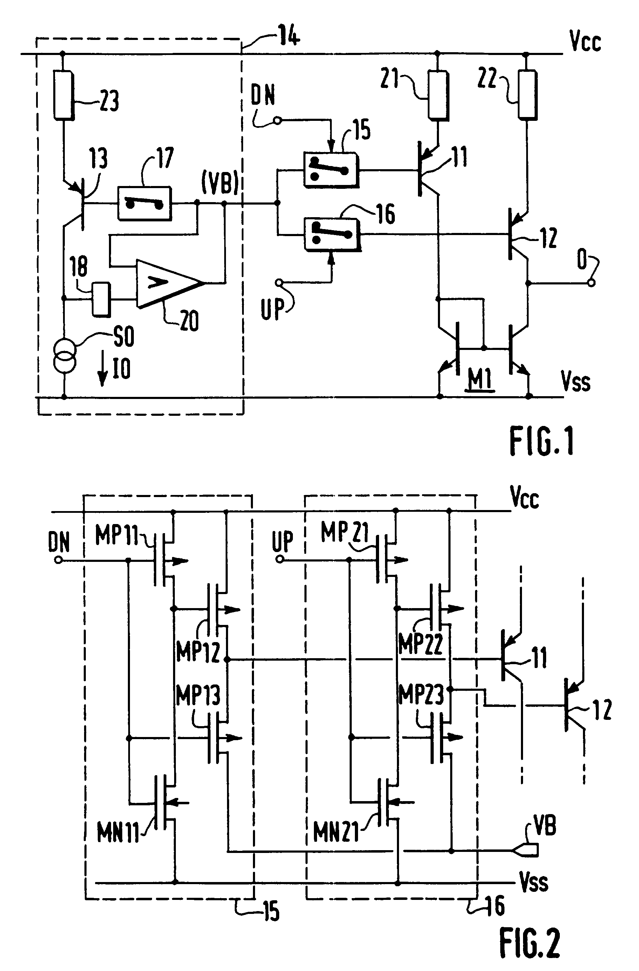

Le schéma de principe d'un circuit pompe de charge selon l'invention est montré à la figure 1,

Entre la borne d'alimentation positive Vcc et la borne d'alimention négative Vss sont disposés en parallèle un premier transistor bipolaire pnp 11 dont l'émetteur est relié à la borne Vcc via une résistance d'émetteur 21, et un deuxième transistor 12 de même type dont l'émetteur est relié à la borne Vcc via une résistance d'émetteur 22 de valeur égale à la résistance 21. Le collecteur du premier transistor 11 est connecté à l'entrée d'un miroir de courant M1, à transistors bipolaires npn, dont la sortie est connectée au collecteur du deuxième transistor 12 pour former un noeud représentant la borne de sortie O du circuit pompe de charge. Les transistors et résistances d'émetteur 11, 21 respectivement 12, 22 constituent respectivement les première et deuxième sources de courant de la pompe de charge. La base du premier transistor 11 est reliée à la sortie d'un générateur de tension de référence 14 présentant en sortie une tension de référence VB, via un commutateur à transistor 15 commandé par un signal de descente DN. D'une manière similaire, le deuxième transistor 12 a sa base reliée à la même sortie du générateur de tension de référence 14 via un autre commutateur à transistor 16 lequel est commandé par le signal de montée UP. Les signaux de descente DN et de montée UP sont ceux fournis par un comparateur de phase auquel le circuit pompe de charge est associé dans le but de former une boucle à verrouillage de phase, comparateur de phase connu et non représenté sur la figure. Ces signaux ont la forme d'impulsions à rapport cyclique petit et sont modulés en largeur d'impulsion.

Le générateur de tension de référence 14 est constitué essentiellement d'un troisième transistor 13 de construction semblable aux premier et deuxième transistors 11, 12, dont l'émetteur est relié à la borne d'alimentation Vcc via une résistance d'émetteur 23 de valeur égale à celle des résistances d'émetteur 21 et 22 des premier et deuxième transistors. Le troisième transistor 13 est relié à la borne d'alimentation Vss via une source de courant de référence So débitant un courant de référence Io fixé.

Des moyens sont en outre prévus tels qu'ils imposent que le courant traversant le troisième transistor 13 soit égal au courant Io de ladite source de courant de référence So. Lesdits moyens sont essentiellement constitués d'un amplificateur de contre-réaction 20. Une première entrée de cet amplificateur 20 est reliée au noeud formé entre le collecteur du troisième transistor 13 et la source de courant So, cette liaison comportant avantageusement l'insertion d'un dispositif de décalage de tension 18. Une seconde entrée de l'amplificateur 20 est reliée à la base du troisième transistor 13, cette liaison comportant avantageusement l'insertion d'un interrupteur 17 à transistor, fermé en permanence. Comme on le verra plus en détail par la suite, l'interrupteur 17 est formé d'un transistor de même type et de construction semblable de ceux des transistors des commutateurs 15 et 16 qui réalisent l'activation cyclique des premier 11 et deuxième 12 transistors. La sortie de l'amplificateur 20 est connectée à la deuxième entrée de cet amplificateur et présente ladite tension de référence VB qui est à appliquer cycliquement aux premier 11 et deuxième 12 transistors de la pompe de charge. Dans un tel générateur de tension de référence 14, on a donc constitué des moyens totalement similaires aux premier et deuxième transistors 11 et 12 de la pompe de charge de sorte que lorsque ces transistors sont activés ils reproduisent exactement le courant de référence Io.

On se reporte maintenant à la figure 2 qui représente un exemple préféré de réalisation des commutateurs 15 et 16 schématisés à la figure 1. Les commutateurs 15 et 16 sont ici réalisés à l'aide de transistors à effet de champ de type MOS. Le commutateur 15 reçoit à l'entrée la commande de descente DN qui est appliquée sur la grille d'une paire de transistors MP11 et MN11 disposés en série entre les bornes d'alimentation Vcc et Vss. Le transistor MP11 est à canal p et le transistor MN11 est à canal n. Cette paire de transistors fournit en sortie un signal logique inverse de celui de la commande de descente DN. Une autre paire de transistors MOS à canal p respectivement MP12 et MP13 est disposée en série entre la borne d'alimentation Vcc et le noeud présentant la tension de référence VB.

Le transistor MP12 référencé à la borne d'alimentation Vcc reçoit sur sa grille le signal de descente inversé en sortie de la paire de transistors MP11 et MN11. Le transistor MP13 référencé à la tension de référence VB, reçoit sur sa grille le signal de descente DN. Ainsi les transistors MP12 et MP13 forment un commutateur, le noeud commun à ces deux transistors étant soit porté à la tension Vcc soit porté à la tension VB en fonction de la commande de descente DN, noeud qui est connecté à la base du premier transistor 11 de la pompe de charge.

Le commutateur 16 est construit d'une manière totalement similaire à celle du commutateur 15. Il reçoit à son entrée la commande de montée UP appliquée à la grille d'une paire de transistors MOS MP21 respectivement MN21 formant inverseur du signal de montée UP. De même une deuxième paire de transistors MP22 et MP23 disposée entre la borne Vcc et la connexion présentant la tension de référence VB a sa sortie constituée par le noeud commun de liaison entre ces transistors, noeud qui est relié directement à la base du deuxième transistor 12 de la pompe de charge.

Lorsque le premier transistor 11 de la pompe de charge est activé, le transistor MP13 est passant et fournit à la base du transistor 11 la tension de référence VB. De même, lorsque le deuxième transistor 12 de la pompe de charge est activé, le transistor MP23 est passant et applique à la base de ce transistor 12 la tension de référence VB. Comme il a été indiqué précédemment, dans le générateur de tension de référence 14, le transistor constituant l'interrupteur 17, fermé en permanence, est constitué d'un transistor MOS à canal p de construction identique aux transistors MP13 et MP23 de sorte que la tension de référence VB prend en compte la chute de tension dans chacun de ces transistors. Ainsi le courant de référence Io est exactement reproduit dans les premier 11 et deuxième 12 transistors lorsqu'ils sont activés.

Les premier et deuxième transistors 11 et 12 de la pompe de charge, lorsqu'ils sont activés simultanément, sont polarisés à la même tension de référence VB de sorte que le bruit présenté par cette tension se trouve essentiellement éliminé à la sortie O de la pompe de charge.

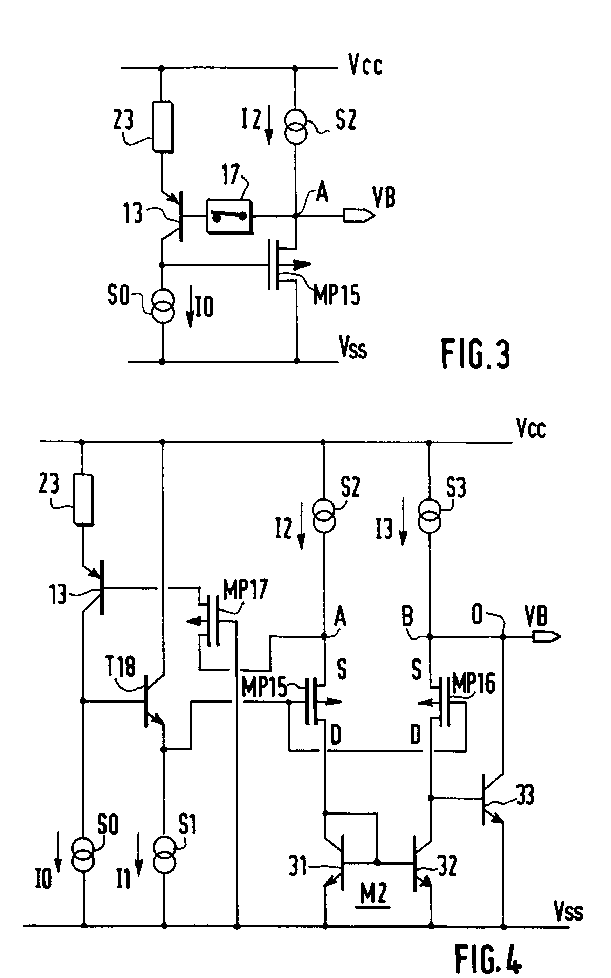

La figure 3 représente un exemple très schématique pour la réalisation d'un amplificateur de contre-réaction tel que l'amplificateur 20 de la figure 1. L'amplificateur de contre-réaction est ici essentiellement réalisé au moyen d'un transistor MP15 de type à effet de champ MOS à canal p, dont la grille est connectée au noeud reliant le collecteur du troisième transistor 13 à la source de courant de référence So. Le trajet principal de courant du transistor MP15 est disposé entre la borne d'alimentation Vss et un noeud de connection A lequel constitue la sortie à la tension de référence VB, et qui est connecté en outre à la base du troisième transistor 13 via l'interrupteur 17, et est relié à la borne d'alimentation Vcc via une source de courant S2. La tension base-collecteur du troisième transistor 13 est donc déterminée par la tension de seuil du transistor MP15 augmentée de la chute de tension dans l'interrupteur 17. Le transistor MP15 absorbe le courant de la source de courant S2 de manière à porter le noeud A à la tension va telle que le troisième transistor 13 débite le courant Io de la source de courant de référence So. La tension de référence VB est créée sous une impédance d'autant plus faible que la source de courant S2 débite un courant I2 plus élevé. Elle est apte à réagir à tout appel de courant de base des premier et deuxième transistors 11 et 12 de la pompe de charge.

La figure 4 représente un exemple de réalisation préféré pour l'ensemble du générateur de tension de référence 14 représenté à la figure 1. Le troisième transistor 13 est à nouveau représenté sur la figure muni de sa résistance d'émetteur 23 et de la source de courant de référence So en série avec ce transistor.

Un transistor bipolaire T18 de type npn a sa base connectée au collecteur du troisième transistor 13 tandis que son émetteur est relié à la borne d'alimentation Vss via une autre source de courant S1 débitant un courant I1, et son collecteur est directement connecté à la borne d'alimentation Vcc. Le transistor T18 réalise ici le dispositif dit décaleur de tension symbolisé en 18 à la figure 1. A la base du troisième transistor 13, est connectée une électrode du trajet principal de courant d'un transistor MP17 de type MOS à canal p, dont la grille est connectée à la borne d'alimentation Vss. Le transistor MP17 constitue l'interrupteur fermé en permanence représenté à la référence 17 aux figures 1 et 3. L'amplificateur de contre-réaction comporte maintenant un premier transistor d'entrée MP15 de type MOS à canal p ainsi qu'un deuxième transistor d'entrée MP16 de même type, transistors dont les grilles sont interconnectées entre elles et connectées à l'émetteur du transistor T18. La source S du premier transistor d'entrée MP15 reçoit la tension de sortie du transistor MP17 jouant le rôle d'interrupteur fermé en permanence et est également reliée à la borne d'alimentation Vcc via la source de courant S2 telle que celle décrite à la figure 3, débitant un courant I2. La source S du deuxième transistor d'entrée MP16 constitue la borne de sortie de l'amplificateur, elle est également reliée à la borne d'alimentation Vcc via une autre source de courant S3, débitant un courant I3. Le drain D du premier transistor d'entrée MP15 est relié à la borne d'alimentation Vss via l'entrée d'un miroir de courant M2 à transistors bipolaires npn 31 et 32. La sortie du miroir de courant M2 constituée par le collecteur du transistor 32 est reliée d'une part au drain D du deuxième transistor d'entrée MP16 et d'autre part à la base d'un transistor de sortie 33 de type bipolaire npn qui a son émetteur connecté à la borne d'alimentation Vss et son collecteur connecté à la borne de sortie O de l'amplificateur. Le noeud de connexion A est celui déjà décrit à propos de la figure 3. On a désigné par B un noeud de connexion homologue du noeud A reliant la source de courant S3 à la source S du deuxième transistor d'entrée MP16. L'amplificateur de contre-réaction ainsi réalisé a un gain en puissance plus élevé que celui schématisé à la figure 3. A la différence du montage représenté à la figure 3, le noeud A est maintenant distinct de la sortie de l'amplificateur (noeud B) mais la tension développée au noeud A est précisément reproduite au noeud B sous une impédance encore plus faible. Le courant I2 délivré par la source de courant S2 est choisi en fonction des besoins et ce courant ne nécessite pas d'être fixé avec une grande précision. Le courant I3 délivré par la source de courant S3 est choisi comme étant supérieur au courant I2. Le comparateur formé par les transistors MP15, MP16, et le miroir de courant M2 imposent que les deux transistors d'entrée MP15 et MP16 soient parcourus par un courant identique égal à I2. Le transistor de sortie 33 absorbe sur le noeud B la différence de courant I3 - I2 (en l'absence de consommation en sortie). La tension obtenue au noeud B est donc précisément une reproduction de la tension au noeud A de sorte que la tension de référence VB est produite sous basse impédance.

Les éléments essentiels constitutifs de l'amplificateur de contre-réaction composé de transistors MOS à canal p et de transistors bipolaires de type npn offrent une réaction très rapide à tout appel de courant sur le générateur de tension de référence VB. Un tel générateur est donc susceptible d'alimenter une pluralité de premières et deuxièmes sources de courant fonctionnant en parallèle, pluralité qui peut être rendue programmable selon les besoins de l'utilisateur. Il est clair que le courant consommé en permanence par un générateur de tension de référence de ce type reste relativement peu élevé si il est comparé à plusieurs dizaines de premières et deuxièmes sources de courant fonctionnant en parallèle.

Si dans les exemples décrits précédemment, une combinaison de transistors bipolaires et de transistors à effet de champ MOS a été utilisée, d'autres réalisations sont également possibles utilisant uniquement des transistors bipolaires ou encore uniquement des transistors à effet de champ. Toutefois, les exemples décrits représentent un mode de construction préféré.

## Revendications

1. Circuit pompe de charge comportant à partir d'une première borne d'alimentation (Vcc), une première (11,21) et une deuxième (12,22) source de courant de construction semblable, dont le courant débité en direction d'une deuxième borne d'alimentation (Vss) est nominalement identique, lesdites sources étant activées indépendamment et cycliquement par des signaux de commande, respectivement un signal dit de descente (DN) et un signal dit de montée (VP), circuit qui comporte également un miroir de courant (M1) dont l'entrée est insérée dans la liaison de la première source de courant (11,21) vèrs la deuxième borne d'alimentation (Vss), et dont la sortie (O) est connectée à la sortie de la deuxième source de courant (12,22), connexion qui constitue une borne de sortie (O) du circuit pompe de charge,
les première et deuxième sources de courant étant essentiellement constituées respectivement d'un premier et d'un deuxième transistors, caractérisé en ce que, l'électrode de commande de chacun d'eux est reliée à la sortie (VB) d'un générateur (14) de tension de référence, commun aux deux transistors, via, pour le premier transistor (11), un premier commutateur à transistors (15) commandé par le signal de descente (DN), et pour le deuxième transistor (12), via un deuxième commutateur (16) à transistors commandé par le signal de montée (UP), et en ce que le générateur de tension de référence (14) comporte un troisième transistor (13), de construction semblable au premier (11) et au deuxième (12) transistor, une source de courant de référence (So) en série avec le troisième transistor (13), et des moyens (20) pour imposer que le courant traversant ce troisième transistor soit égal au courant (Io) de ladite source de courant de référence (So), l'électrode de commande du troisième transistor présentant ladite tension de référence (VB) à appliquer aux électrodes de commande des premier et deuxième transistors.

2. Circuit pompe de charge selon la revendication 1, caractérisé en ce que le générateur de tension de référence (14) comporte un amplificateur de contre-réaction (20), dont une première entrée est reliée à un noeud formé entre la source de courant (So) de référence et l'électrode de sortie du troisième transistor (13), dont une seconde entrée est reliée à l'électrode de commande de ce troisième transistor (13) et dont la sortie fournit ladite tension de référence (VB).

3. Circuit pompe de charge selon la revendication 2, caractérisé en ce qu'un quatrième transistor (17), tenant lieu d'interrupteur fermé en permanence, est inséré entre la seconde entrée de l'amplificateur de contre-réaction (20) et l'électrode de commande du troisième transistor (13), ce quatrième transistor (17) étant de construction semblable à ceux des transistors du premier (15) et du deuxième (16) commutateur qui commandent l'activation cyclique des premier (11) et deuxième (12) transistors de la pompe de charge.

4. Circuit pompe de charge selon l'une des revendications 2 ou 3, caractérisé en ce qu'un dispositif de décalage de tension (18) est en outre inséré dans la liaison à la première entrée de l'amplificateur de contre-réaction (20).

5. Circuit pompe de charge selon l'une des revendications 1 à 4, caractérisé en ce que les premier (11), deuxième (12) et troisième (13) transistors sont de type bipolaire pnp, et en ce que le miroir de courant (M1) est à transistors bipolaires de type npn.

6. Circuit pompe de charge selon la revendication 5, caractérisé en ce que les premier (15) et deuxième (16) commutateurs sont constitués de transistors à effet de champ complémentaires, de type MOS.

7. Circuit pompe de charge selon la revendication 6, caractérisé en ce que l'amplificateur de contre-réaction comporte un premier (MP15) et un deuxième (MP16) transistors d'entrée, de type MOS à canal p, dont les grilles sont interconnectées, la source du premier transistor d'entrée (MP15) recevant la tension de sortie du quatrième transistor (17) et étant reliée à une première source annexe de courant (S2) alimentée par la première borne d'alimentation (Vcc), la source (B) du deuxième transistor d'entrée (MP16), constituant la borne de sortie (O) de l'amplificateur, étant reliée à une deuxième source annexe de courant (S3) également alimentée par la première borne d'alimentation (Vcc), le drain du premier transistor d'entrée étant relié à l'entrée d'un deuxieme miroir de courant (M2) à transistors bipolaires npn, miroir dont la sortie est connectée au drain du deuxième transistor d'entrée (MP16) ainsi qu'à la base d'un transistor de sortie (33) de type bipolaire npn, lequel a son émetteur connecté à la deuxième borne d'alimentation (Vss) et son collecteur connecté à la borne de sortie (O) de l'amplificateur.

8. Synthétiseur de fréquence incorporant au moins un circuit pompe de charge selon l'une quelconque des revendications 1 à 7.

9. Sythétiseur de fréquence selon la revendication 8, caractérisé en ce qu'un même générateur de tension de référence alimente une pluralité, en quantité programmable, de premières et deuxièmes sources de courant fonctionnant en parallèle.

## Patentansprüche

1. Ladepumpenschaltung, die, ausgehend von einem ersten Speiseanschluß (Vcc), eine erste Stromquelle (11, 21) und eine zweite Stromquelle (12, 22) gleicher Konstruktion enthält, deren einem zweiten Speiseanschluß (Vss) zugeführter Strom nominell identisch ist, wobei die genannten Quellen unabhängig voneinander und zyklisch durch Steuersignale aktiviert werden, wobei diese Signale als Abwärtssignal (DN) bzw. als Aufwärtssignal (UP) bezeichnet werden, wobei diese Schaltungsanordnung ebenfalls eine Stromspiegelschaltung (M1) aufweist, deren Eingang in der Verbindung zwischen der ersten Stromquelle (11, 21) und dem zweiten Speiseanschluß (Vss) vorgesehen ist, und mit einem Ausgang (O), der mit dem Ausgang der zweiten Stromquelle (12, 22) verbunden ist, wodurch eine Ausgangsklemme (O) der Ladepumpenschaltung gebildet wird, wobei die erste und die zweite Stromquelle im wesentlichen einen ersten bzw. einen zweiten Transistor aufweisen, dadurch gekennzeichnet, daß die Steuerelektroden der beiden genannten Transistoren mit dem Ausgang (VB) eines Bezugsspannungsgenerators (14) gekoppelt sind, der den beiden Transistoren über einen ersten Transistorschalter (15) gemeinsam ist, der von dem Abwärtssignal (DN) gesteuert wird, für den ersten Transistor (11), und über einen zweiten Transistorschalter (16), der von dem Aufwärtssignal (UP) gesteuert wird, für den zweiten Transistor (12), und wobei der Bezugsspannungsgenerator (14) einen dritten Transistor (13) aufweist, dessen Konstruktion der der beiden erstgenannten Transistoren (11) bzw. (12) entspricht, weiterhin mit einer Bezugsstromquelle (So) in Reihe mit dem dritten Transistor (13), und mit Mitteln (20) um den Strom durch diesen dritten Transistor dem Strom (Io) der genannten Bezugsstromquelle (So) entsprechend zu machen, wobei die Steuerelektrode des dritten Transistors die genannte, den Steuerelektroden des ersten und des zweiten Transistors zuzuführende Bezugsspannung (VB) trägt.

2. Ladepumpenschaltung nach Anspruch 1, dadurch gekennzeichnet, daß der Bezugsspannungsgenerator (14) einen Rückkopplungsverstärker (20) aufweist, dessen erster Eingang mit einem Knotenpunkt zwischen der Bezugsstromquelle (So) und der Ausgangselektrode des dritten Transistors (13) gekoppelt ist, dessen zweiter Eingang mit der Steuerelektrode dieses dritten Transistors (13) gekoppelt ist und dessen Ausgang die genannte Bezugsspannung (VB) liefert.

3. Ladepumpenschaltung nach Anspruch 2, dadurch gekennzeichnet, daß ein vierter Transistor(17), der als normalerweise geschlossener Schalter wirksam ist, zwischen dem zweiten Eingang des Rückkopplungsverstärkers (20) und der Steuerelektrode des dritten Transistors (13) vorgesehen ist, wobei dieser vierte Transistor (17) eine Konstruktion aufweist, die der der Transistoren des ersten (15) und des zweiten Schalters (16) entspricht, die die zyklische Aktivierung des ersten (11) ersten und des zweiten Transistors (12) der Ladepumpe steuern.

4. Ladepumpenschaltung nach Anspruch 2 oder 3, dadurch gekennzeichnet, daß außerdem ein Spannungsschieber (18) in der Verbindung mit dem ersten Eingang des Rückkopplungsverstärkers (20) vorgesehen ist.

5. Ladepumpenschaltung nach einem der Ansprüche 1 bis 4, dadurch gekennzeichnet, daß der erste (11), der zweite (12) und der dritte Transistor (13) bipolare PNP-Transistoren sind, und daß der Stromspiegel (M1) bipolare NPN-Transistoren aufweist.

6. Ladepumpenschaltung nach Anspruch 5, dadurch gekennzeichnet, daß der erste (15) und der zweite Schalter (16) durch komplementäre MOS-Feldeffekttransistoren gebildet sind.

7. Ladepumpenschaltung nach Anspruch 6, dadurch gekennzeichnet, daß der Rückkopplungsverstärker einen ersten (MP15) und einem zweiten Eingangstransistor (MP16) vom p-leitenden MOS-TYP aufweist, wobei die Gate-Elektroden miteinander verbunden sind, wobei die Source-Elektrode des ersten Eingangstransistors (MP15) die Ausgangsspannung des vierten Transistor (17) erhält und mit einer ersten zugeordneten Stromquelle (S2) gekoppelt ist, die durch die erste Speiseklemme (Vcc) gespeist wird, wobei die Source-Elektrode (B) des zweiten Eingangstransistors (MP16) die Ausgangsklemme (O) des Verstärkers bildet und mit einer zweiten zugeordneten Stromquelle (S3) gekoppelt ist, die ebenfalls von der ersten Speiseklemme (Vcc) gespeist wird, wobei die Drain-Elektrode des ersten Eingangstransistors mit dem Eingang eines zweiten Styromspiegels (M2) gekoppelt ist, der bipolare NPN-Transistoren aufweist und dessen Ausgang mit der Drain-Elektrode des zweiten Eingangstransistors (MP16) sowie mit der Basis-Elektrode eines bipolaren NPN-Ausgangstransistors (33) gekoppelt ist, dessen Emitter-Elektrode mit der zweiten Speiseklemme (Vss) gekoppelt ist und dessen Kollektor-Elektrode mit der Ausgangsklemme (O) des Verstärkers verbunden ist.

8. Frequenzsynthesizer mit wenigstens einer Ladepumpenschaltung nach einem der Ansprüche 1 bis 7.

9. Frequenzsynthesizer nach Anspruch 8, dadurch gekennzeichnet, daß ein einziger Bezugsspannungsgenerator eine Anzahl erster und zweiter Stromquellen speist, die in Anzahl programmierbar sind und in Parallelschaltung betrieben werden.

## Claims

1. A charge-pump circuit which, starting from a first supply terminal (Vcc), comprises a first current source (11, 21) and a second current source (12, 22) of similar construction, whose current supplied to a second supply terminal (Vss) is nominally identical, said sources being activated independently and cyclically by control signals, referred to as a down signal (DN) and an up signal (UP), respectively, which circuit also comprises a current mirror (M1) having an input arranged in the connection between the first current source (11, 21) and the second supply terminal (Vss), and having an output (O) connected to the output of the second current source (12, 22), thereby forming an output terminal (O) of the charge-pump circuit, the first and the second current source essentially comprising a first and a second transistor, respectively, characterized in that the control electrode of each of said transistors is coupled to the output (VB) of a reference voltage generator (14) common to the two transistors via a first transistor switch (15), controlled by the down signal (DN), for the first transistor (11), and via a second transistor switch (16), controlled by the up signal (UP), for the second transistor (12), and in that the reference voltage generator (14) comprises a third transistor (13) of a construction similar to that of the first (11) and the second (12) transistor, a reference current source (So) in series with the third transistor (13), and means (20) for making the current through this third transistor equal to the current (Io) of said reference current source (So), the control electrode of the third transistor carrying said reference voltage (VB) to be applied to the control electrodes of the first and the second transistor.

2. A charge-pump circuit as claimed in Claim 1, characterized in that the reference voltage generator (14) comprises a feedback amplifier (20) having a first input coupled to a node between the reference current source (So) and the output electrode of the third transistor (13), having a second input coupled to the control electrode of this third transistor (13), and having an output supplying said reference voltage (VB).

3. A charge-pump circuit as claimed in Claim 2, characterized in that a fourth transistor (17), serving as a normally closed switch, is arranged between the second input of the feedback amplifier (20) and the control electrode of the third transistor (13), which fourth transistor (17) is of a construction similar to that of the transistors of the first (15) and the second (16) switch which control the cyclic activation of the first (11) and the second (12) transistor of the charge pump.

4. A charge-pump circuit as claimed in Claim 2 or 3, characterized in that, in addition, a voltage shifter (18) is included in the connection to the first input of the feedback amplifier (20).

5. A charge-pump circuit as claimed in any one of the Claims 1 to 4, characterized in that the first (11), the second (12) and the third (13) transistor are of the bipolar pnp type, and in that the current mirror (M1) comprises bipolar npn transistors.

6. A charge-pump circuit as claimed in Claim 5, characterized in that the first (15) and the second (16) switch are formed by complementary MOS field-effect transistors.

7. A charge-pump circuit as claimed in Claim 6, characterized in that the feedback amplifier comprises a first (MP15) and a second (MP16) input transistor of the p-channel MOS type, having interconnected gates, the source of the first input transistor (MP15) receiving the output voltage of the fourth transistor (17) and being coupled to a first associated current source (S2) fed by the first supply terminal (Vcc), the source (B) of the second input transistor (MP16) forming the output terminal (O) of the amplifier and being coupled to a second associated current source (S3) which is also fed by the first supply terminal (Vcc), the drain of the first input transistor being coupled to the input of a second current mirror (M2) comprising bipolar npn transistors and having an output connected to the drain of the second input transistor (MP16) and to the base of a bipolar npn output transistor (33) having its emitter connected to the second supply terminal (Vss) and having its collector connected to the output terminal (O) of the amplifier.

8. A frequency synthesizer including at least one charge-pump circuit as claimed in any one of the Claims 1 to 7.

9. A frequency synthesizer as claimed in Claim 8, characterized in that a single reference voltage generator feeds a plurality of first and second current sources which are programmable in number and are operated in parallel.
